# EUROPEAN PATENT APPLICATION

(11) **EP 4 404 238 A1**
(43) Date of publication of application: **24.07.2024**
(21) Application number: 22869383.4
(22) Date of filing: 16.09.2022
(51) Int. Cl.: H01J 37/34, C23C 14/34, C23C 14/35

(54) **SPUTTERING TARGET AND METHOD FOR MANUFACTURING SPUTTERING TARGET**

(30) Priority: 16.09.2021 CN 202111086210
(71) Applicant: Plansee (Shanghai) High Performance Material Ltd., Shanghai 201306 (CN); Plansee SE, 6600 Reutte (AT); Plansee Japan Ltd., Tokyo 106-0032 (JP)
(72) Inventor: CHEN, Chao, Shanghai 201306 (CN); LU, Jiandong, Shanghai 201306 (CN); LINKE, Christian, 6600 Reutte (AT); SCHMIDT, Hennrik, 6600 Reutte (AT); KUNIYA, Tsutomu, Kanagawa 245-0012 (JP)
(74) Representative: Ciesla, Dirk
(86) International application number: PCT/CN2022/119247
(87) International publication number: WO 2023/041017

(57) **Abstract**

The present invention provides a sputtering target and a method for manufacturing a sputtering target. The sputtering target includes a tubular backing tube, of which an axis being defined as an axial direction, and a plane in which a radial direction lies being perpendicular to the axial direction; at least two cylindrical target segments juxtaposed along the axial direction on the tubular backing tube; and a bonding material arranged between the tubular backing tube and the at least two cylindrical target segments. At least two ends of the at least two cylindrical target segments facing each other form a tongue-groove-fit with each other in such a way that at least one tongue at one end is overlapped with at least one groove at a respective other end of two adjacent cylindrical target segments, as viewed in the radial and/or the axial direction, the overlap extending at least along a part of a circumference of the corresponding end.

## Description

### TECHNICAL FIELD

The present application relates to a sputtering target and a method for manufacturing the same.

### BACKGROUND

Sputtering is a physical vapor deposition technique that refers to the physical process in which atoms in a solid target are bombarded by energetic ions (usually from a plasma) and ejected from the solid into a gas. Sputtering is generally performed in a vacuum system filled with an inert gas. Under the action of a high-voltage electric field, an argon gas is ionized to generate an argon ion flow, which bombards the target cathode. The sputtered target material atoms or molecules are deposited on the semiconductor chip, glass, or ceramic to form a thin film. Sputtering has the advantages of being capable of producing thin films of high melting point materials at lower temperatures, and maintaining the original composition during the process of producing thin films of alloys and compounds. Therefore, sputtering has been widely used in the manufacture of semiconductor devices and integrated circuits.

Sputtering target materials are materials that produce thin films by sputtering and are manufactured from metals and ceramics. In recent years, there have been demands for further lower power consumption and higher speed of electronic components, and in order to achieve these demands, various high-quality sputtering target materials are required.

Generally, the sputtering target material is mainly composed of a target blank, backing plate, and other parts. The target blank is a target material bombarded by a high-speed ion beam current and belongs to a core part of the sputtering target material. In the sputtering coating process, after the target blank is hit by ions, surface atoms thereof are sputtered, scattered out, and deposited on a substrate to make an electronic film. Due to a lower strength of the high-purity metal has a low strength, the sputtering target material needs to be installed in a special machine to complete the sputtering process. The inside of the machine is a high-voltage and high-vacuum environment. Therefore, the sputtering target blank of the ultra-high-purity metal needs to be joined with the backing plate through a different welding process. The backing plate mainly plays the role of fixing the sputtering target material, and needs to have good electrical and thermal conductivity.

In the prior art, a tubular target material is provided. The tubular target material includes a tubular target body having recesses, and two connecting members having flanges that engage the recesses. The connecting member has a depression in which a solder is present to connect the tubular target body to the connecting members. However, with this target material, as the temperature rises, the solder tends to leak from the joint of the target material.

In the prior art, a target material assembly and a target material unit are further provided. The target material assembly includes a plurality of target material units and a plurality of joining parts. Each of the plurality of target material units possesses a cylindrical target material and a cylindrical base. The cylindrical base is engaged inside the cylindrical target material. The joining part is positioned inside a plurality of target material units, and each of the plurality of target material units includes a gap therebetween. However, with this target material, as the temperature rises, the solder is also easy to leak from the joint of the target material.

In the prior art, a target mounting mechanism is further provided. The target mounting mechanism is mounted with a cylindrical target including a cylindrical support tube and a target material covering the support tube, and including a joining region, the target being connected to a clamp. However, with this target material, as the temperature rises, the solder is also easy to leak from the joint of the target material.

In the prior art, an interlocking cylindrical magnetron cathode and a target material are further provided. The magnetron assembly includes a first unit that allows the target material to be removed from the cathode body. However, with this target material, as the temperature rises, the solder is also easy to leak from the joint of the target material.

In the prior art, a tubular target is further provided. The tubular target is composed of a support tube and a sputtering material tube. The support tube is connected to the sputtering material tube by a threaded connection. An O-ring seal is arranged between the support tube and the sputtering material tube. However, with this target material, as the temperature rises, the solder is also easy to leak from the joint of the target material.

It can be seen from the above that it is a difficult problem in technics most in need of a solution by those skilled in the art so that an improved sputtering target can be provided in view of the deficiencies in the prior art. The said sputtering target is capable of preventing the leakage of the solder from the joint of the target material, significantly improve the assembly accuracy and assembly stability, and achieve stable quality, high yield rate, and cost savings.

### SUMMARY

### Problem to be solved

It is an object of the present application to overcome the drawbacks of the prior art and to provide an improved sputtering target and a method for manufacturing a sputtering target. In accordance with the improved sputtering target and methods for manufacturing the sputtering target provided herein, stable quality, high yield rate, and cost saving are achieved.

### Method for solving the problem

A first aspect of the present application relates to a sputtering target. The sputtering target includes:
a tubular backing tube, of which an axis being defined as an axial direction, and a plane in which a radial direction lies being perpendicular to the axial direction;
at least two cylindrical target segments juxtaposed along the axial direction on the tubular backing tube; and
a bonding material arranged between the tubular backing tube and the at least two cylindrical target segments,
wherein at least two ends of the at least two cylindrical target segments facing each other form a tongue-groove-fit with each other in such a way that at least one tongue at one end is overlapped with at least one groove at a corresponding other end of two adjacent cylindrical target segments, as viewed in the radial and/or the axial direction, the overlap extending at least along a part of a circumference of the corresponding end.

In some embodiments, the at least two ends of the at least two cylindrical target segments facing each other form a tongue-groove-fit with each other in such a way that one tongue at the one end is overlapped with one groove at the corresponding other end of two adjacent cylindrical target segments as viewed in the radial and/or the axial direction.

In some embodiments, the at least two ends of the at least two cylindrical target segments facing each other form a tongue-groove-fit with each other in such a way that one end with more than one tongue and/or groove is overlapped with the other end with more than one tongue and/or groove, such that each tongue is overlapped with a corresponding faced groove, or each groove is overlapped with a corresponding faced tongue as viewed in the radial direction.

In some embodiments the at least one tongue at one end and at least one groove of corresponding another end are arranged within an inner extent of 75% of a maximum thickness in a radial plane of the corresponding ends of two adjacent cylindrical target segments as viewed in the radial direction.

In some embodiments, the overlap extends along an entire circumference of two adjacent target segments to provide the tongue-groove-fit, as viewed in the radial plane.

In some embodiments, the tongue is a ridge having a rectangular cross-section and two parallel side walls, and the groove is a trough having a rectangular cross-section and two parallel side walls.

In some embodiments, the tongue-groove-fit is established segment by segment along the circumference of two adjacent target segments, as viewed in the radial and/or axial direction.

In some embodiments, a protrusion is arranged on one member of the tongue and the groove and a corresponding trough is arranged on the other member of the tongue and the groove, the protrusion and the trough being engageable by relative rotation between two adjacent target segments.

In some embodiments, a circumferential sealing member is further included as extending circumferentially along a gap between two adjacent target segments.

In some embodiments, the circumferential sealing member is arranged in the trough formed in two adjacent target segments.

In some embodiments, the target segment is made of a metallic material.

In some embodiments, the target segment is made of a molybdenum- and/or tungsten-based material.

In some embodiments, the bonding material is a solder.

In some embodiments, the bonding material is an indium solder or an indium alloy solder.

In some embodiments, the sputtering target further includes at least one cylindrical target segment arranged on the tubular backing tube. The tubular backing tube extends along the axial direction through at least 90% of a total length of the at least one cylindrical target segment.

In some embodiments, the sputtering target further includes a stop member for the target segment adjacent to the stop member, the stop member being monolithically (or integrally) formed with and radially protruding from the tubular backing tube at an axial end region of the tubular backing tube and extending at least along a part of a circumference of the tubular backing tube.

In some embodiments, the sputtering target further includes a circumferential sealing member inserted between the stop member and the adjacent target segment to prevent leakage of the bonding material.

A second aspect of the present application relates to a method for manufacturing a sputtering target. The method includes:
providing a tubular backing tube and at least two cylindrical target segments, an axis of the tubular backing tube being defined as an axial direction, a plane in which a radial direction lies being perpendicular to the axial direction, and the ends of the target segments having at least one tongue or at least one groove;
providing a bonding material arranged between the tubular backing tube and the at least two cylindrical target segments;
juxtaposing cylindrical target segments along the axial direction on the tubular backing tube, at least two ends of the at least two cylindrical target segments facing each other forming a tongue-groove-fit with each other in such a way that at least one tongue at one end is overlapped with at least one groove at a corresponding other end of two adjacent cylindrical target segments, as viewed in the radial and/or axial direction, the overlap extending at least along a part of a circumference of the respective end; and
bonding the at least two cylindrical target segments to the tubular backing tube.

### Effects

In the embodiments of the present application, the sputtering target can prevent the solder leakage from the joint of the target material, significantly improve assembly accuracy and assembly stability, and achieve stable quality, high yield rate, and cost saving.

In accordance with the embodiments, the method for manufacturing the sputtering target can achieve a product of stable quality and high yield rate with cost saving.

### BRIEF DESCRIPTION OF THE DRAWINGS

FIG. 1 is a schematic illustration of a sputtering target according to a first embodiment of the present application;
FIG. 2 is an enlarged partial view at site B in the sputtering target of FIG. 1;
FIG. 3 is an enlarged partial view at site A in the sputtering target of FIG. 1; and
FIG. 4 is a flowchart of a method for manufacturing a sputtering target according to a second embodiment of the present application.

### DETAILED DESCRIPTION

The technical solutions according to the present application are clearly and completely described below with reference to the accompanying drawings, and it is obvious that the described embodiments are a part of the embodiments of the present application, rather than all the embodiments. Based on the embodiments in the present application, all the other embodiments obtained by those skilled in the art without making any inventive effort fall within the scope of protection of the present application.

In the description of the present application, it should be noted that the orientation or positional relationships indicated by the terms "center", "upper", "lower", "top", "bottom", "inner", "outer", and the like, are based on the orientation or positional relationships shown in the accompanying drawings, which are only for the convenience of describing the present application and simplifying the description, rather than indicating or implying that the referenced devices or elements must have a particular orientation, be constructed and operated in a particular orientation, and thus should not be construed as limiting the application.

In the description of the present application, it should be noted that, unless expressly stated or limited otherwise, the terms "arrange", "connect", and "joint" are to be interpreted broadly and may, for example, be fixedly connected, detachably connected, or integrally connected. The specific meaning of the above terms in the present application can be understood in detail by those skilled in the art.

In addition, the technical features involved in the different embodiments of the present application described below can be combined with each other as long as they do not conflict with each other.

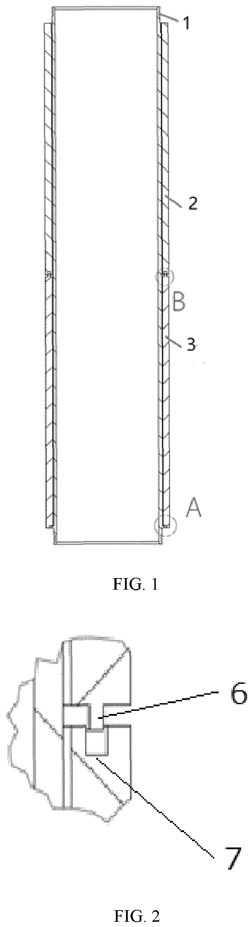

FIG. 1 is a schematic illustration of a sputtering target according to a first embodiment of the present application. As shown in FIG. 1, the sputtering target includes a tubular backing tube 1 and cylindrical target segments 2 and 3. The number of the target segments is not limited to two, but may be three or more. An axis of the backing tube 1 is defined as an axial direction (a top-bottom direction in FIG. 1). A plane in which a radial direction (a left-right direction in FIG. 1) of the backing tube 1 lies is perpendicular to the axial direction. The cylindrical target segments 2 and 3 are arranged on the backing tube 1 which extends along the axial direction through a total length of the target segments 2 and 3. In some embodiments, the target segments 2 and 3 are made of a metallic material, for example a molybdenum- and/or tungsten-based material. A bonding material is arranged between the backing tube 1 and the target segments 2 and 3. In some embodiments, the bonding material is a solder, such as an indium solder or an indium alloy solder. A stop member is arranged at a lower side (site A in FIG. 1) of the target segment 3.

FIG. 2 is an enlarged partial view at site B in FIG. 1. As shown in FIG. 2, the two ends of the target segments 2 and 3 facing each other form a tongue-groove-fit with each other in such a way that one tongue 6 at an end of the target segment 2 is overlapped with one groove 7 at the corresponding other end of the target segment 3, as viewed in the radial and/or axial direction, wherein the overlap extends along a part of the circumference of the corresponding end. The number of tongues 6 and grooves 7 is not limited to one. Alternatively, a plurality of tongues 6 and grooves 7 may be provided. For example, the tongue-groove-fit is established segment by segment along the circumference of two adjacent target segments (especially in the case of a combination with an engagement mechanism described below). In some embodiments, the overlap extends along the entire circumference of the corresponding end. In some embodiments, the tongue 6 is a ridge having a rectangular cross-section and two parallel side walls, and the groove 7 is a trough having a rectangular cross-section and two parallel side walls, but not limited thereto. The tongue 6 and the groove 7 may be of other suitable configurations, such as a tongue having a tapered or conical cross-section and a corresponding tapered or conical groove. In some embodiments, the tongue 6 is arranged with a protrusion and the groove 7 is arranged with a corresponding trough, or the tongue 6 is arranged with a trough and the groove 7 is arranged with a corresponding protrusion. Therefore, through the relative rotation between the target segments 2 and 3, the protrusions are engaged with the though, that is, combined with the bayonet structure, but not limited thereto. The tongue 6 and the groove 7 may also be provided with a groove/trough/step.

In some embodiments, the tongue 6 and the groove 7 are arranged within an inner extent of 75% of a maximum thickness in a radial plane of each corresponding end of the target segments 2, 3, which are not limited thereto. The tongue 6 and the groove 7 may also be arranged in other suitable positions.

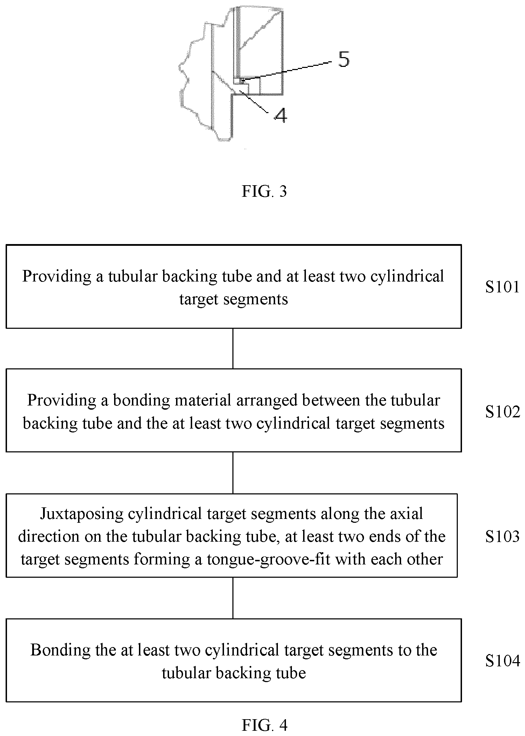

FIG. 3 is an enlarged partial view at site A in FIG. 1. As shown in FIG. 3, the stop member 4 is formed monolithically (or integrally) with and protrudes radially along the backing tube 1 at an axial end region of the backing tube 1, and extends along at least part of the circumference of the backing tube 1. That is, the stop member 4 is a monolithic part of the backing tube 1, and the stop member 4 and the adjacent target segment 3 form a tongue-groove-fit. "Monolithically formed" (or "integrally formed") shall include forming in one step from the same material or joining by welding, gluing, etc. A circumferential sealing member 5 preventing leakage of the bonding material is inserted between the stop member 4 and the target segment 3. In some embodiments, the stop member 4 extends continuously along the circumference of the backing tube 1. In some embodiments, the sealing member 5 is an O-ring made of an elastomeric material and compressed between the target segment 3 and the stop member 4, but not limited thereto. Other suitable structures may also be employed.

In some embodiments, the stop member 4 is a protruding step part, but is not limited thereto. Other suitable structures may also be employed. The protruding step part may be a protruding ridge with two parallel side walls, including a substantially rectangular cross-section with two parallel side walls, but is not limited thereto. Other suitable structures may also be employed, such as a step part with a tapered or conical cross-section and a corresponding tapered or conical groove.

In some embodiments, the stop member 4 has a circumferential member with a radially protruding lip pressed against the stop member 4 and/or the target segment 3 to provide a sealing function, but is not limited thereto. Other suitable structures may also be employed. That is, a circumferential seal extends circumferentially along the gap between two adjacent target segments, such as a lip, a T-profile, a foil, and an annular metal piece with a spring function.

In some embodiments, the stop member 4 includes, for example, a groove or tongue extending along the axial direction, but is not limited thereto. Other suitable structures may also be employed.

Existing sputtering target materials are generally planar joints where multiple target segments are spliced together, and there is no fixed target material boss on the surface of the backing tube. Compared with the existing cutting method, the sputtering target according to the present application forms a tongue-groove-fit between two ends of the target segments facing each other, which significantly improves the assembly accuracy and assembly stability. During the application process of the target material, as the temperature rises, the solder is also prevented from leaking from the joint of the target material.

Hereinafter, suitable examples of the present application are described, but the embodiments of the present application are not limited thereto.

### <Example 1>

The sputtering target in Example 1 includes: a tubular backing tube 1, cylindrical target segments 2 and 3 made of molybdenum, a stop member 4, and a sealing member 5. The target segments 2 and 3 are arranged on the backing tube 1, and the backing tube 1 extends along the axial direction through a total length of the target segments 2 and 3. An indium solder is arranged between the backing tube 1 and the target segments 2 and 3. The two ends of the target segments 2 and 3 facing each other form a tongue-groove-fit with each other in such a way that one tongue 6 at an end of the target segment 2 is overlapped with one groove 7 at the corresponding other end of the target segment 3, as viewed in the radial and axial directions, wherein the overlap extends along a part of a circumference of the corresponding end. The tongue 6 is a ridge having a rectangular cross-section and two parallel side walls. The groove 7 is a trough having a rectangular cross-section and two parallel side walls. The tongue 6 is arranged with a protrusion and the recess 7 is arranged with a corresponding trough. The protrusion thus engages the trough by relative rotation between the target segments 2 and 3. A stop member 4 is arranged at the target segment 3. The stop member 4 is formed monolithically (or integrally) with the backing tube 1 in an axial end region of the backing tube 1 using the same material as the backing tube 1 and protrudes radially along the backing tube 1 and extends continuously along a circumference of the backing tube 1. The stop member 4 is a protruding step part, having a protruding ridge with two parallel side walls, including a substantially rectangular cross-section with two parallel side walls. By applying the sputtering target of the present application, the leakage of the solder from a lowermost end of the target material is prevented, the assembly precision and assembly stability are significantly improved, and the production efficiency is greatly improved.

### < Example 2>

The sputtering target in Example 2 includes: a tubular backing tube 1, cylindrical target segments 2 and 3 made of tungsten, a stop member 4, and a sealing member 5. The target segments 2 and 3 are arranged on the backing tube 1, and the backing tube 1 extends along the axial direction through a total length of the target segments 2 and 3. A plurality of target segments may also be arranged between the target segments 2 and 3. The two ends of the target segments facing each other form a tongue-groove-fit with each other in such a way that the two tongues at the end of one target segment are overlapped with the two grooves at the corresponding other end of the other target segment, as viewed in the radial direction, wherein the overlap extends along an entire circumference of the corresponding end. An indium alloy solder is arranged between the backing tube 1 and the target segments 2 and 3. A stop member 4 is arranged at the target segment 3. The stop member 4 is formed monolithically (or integrally) with the backing tube 1 in an axial end region of the backing tube 1 in such a manner as to be welded and radially protruded along the backing tube 1, and extends continuously along a circumference of the backing tube 1. The stop member 4 has a circumferential member with a radially protruding lip pressed against the stop member 4 and/or the target segment 3 to provide a sealing function. By applying the sputtering target of the present application, the leakage of the solder from a lowermost end of the target material is prevented, the assembly precision and assembly stability are significantly improved, and the production efficiency is greatly improved.

### < Example 3>

The sputtering target in this Example 3 includes: a tubular backing tube 1, cylindrical target segments 2 and 3 made of tantalum, a stop member 4, and a sealing member 5. The target segments 2 and 3 are arranged on the backing tube 1, and the backing tube 1 extends along the axial direction through a total length of the target segments 2 and 3. A plurality of target segments may also be arranged between the target segments 2 and 3. The two ends of the target segments facing each other form a tongue-groove-fit with each other in such a way that the three tongues at the end of one target segment are overlapped with the three grooves at the corresponding other end of the other target segment, as viewed in the radial direction and axial direction, wherein the overlap extends along an entire circumference of the corresponding end. An indium alloy solder is arranged between the backing tube 1 and the target segments 2 and 3. A stop member 4 is arranged at the target segment 3. The stop member 4 is formed monolithically (or integrally) with the backing tube 1 in an axial end region of the backing tube 1 in such a manner as to be connected with glue and radially protrudes along the backing tube 1, and extends continuously along a circumference of the backing tube 1. The stop member 4 is an annular metal piece having a spring function. By applying the sputtering target of the present application, the leakage of the solder from a lowermost end of the target material is prevented, the assembly precision and assembly stability are significantly improved, and the production efficiency is greatly improved.

Next, a method for manufacturing a sputtering target according to the present application is described in detail.

The method for manufacturing a sputtering target of the second embodiment herein is a method for manufacturing the sputtering target in the first embodiment. As shown in FIG. 4, in step S101, a tubular backing tube and at least two cylindrical target segments are first provided. An axis of the tubular backing tube is defined as an axial direction, and a plane in which a radial direction lies is perpendicular to the axial direction. The ends of the target segments are provided with at least one tongue or at least one groove. Then, in step S102, a bonding material is arranged between the tubular backing tube and the at least two cylindrical target segments. Next, in step S103, the cylindrical target segments are juxtaposed along the axial direction on the tubular backing tube. At least two ends of at least two cylindrical target segments facing each other form a tongue-groove-fit with each other in such a way that the at least one tongue at one end is overlapped with the at least one groove at the corresponding other end of two adjacent cylindrical target segments, as viewed in the radial and/or axial direction, wherein the overlap extends at least along a part of a circumference of the corresponding end. Finally, in step S104, at least two cylindrical target segments are bonded to the tubular backing tube.

The sputtering target according to the first embodiment is prepared by the manufacturing method according to the second embodiment, which effectively solves the problem that the solder easily leaks from the joint of the target material during the application of the target material as the temperature rises. The sputtering target prepared has stable quality and high yield rate compared with the existing processes.

The silver tungsten contact material according to the second embodiment of the present application is an embodiment corresponding to the sputtering target of the first embodiment. Therefore, various points of implementation in the first embodiment are equally applicable to the second embodiment, and are not described in detail herein.

### Industrial applicability

According to the sputtering target and the method for manufacturing the sputtering target involved in the present application, the problem of the solder easily leaking from the joint of the target material during the application of the target material along with temperature rising has been effectively solved. The stable quality, high yield rate, and cost savings have been achieved.

While the present application has been described with reference to the preferred embodiments thereof, it will be understood by those skilled in the art that various changes may be made and equivalents may be substituted for elements thereof without departing from the scope of the present application. Therefore, the scope of the present application should be subject to the protection scope of the claims.

## Claims

1. A sputtering target, comprising:
a tubular backing tube, an axis thereof being defined as an axial direction, and a plane in which a radial direction lies being perpendicular to the axial direction;
at least two cylindrical target segments juxtaposed along the axial direction on the tubular backing tube; and
a bonding material arranged between the tubular backing tube and the at least two cylindrical target segments,
wherein at least two ends of the at least two cylindrical target segments facing each other form a tongue-groove-fit with each other in such a way that at least one tongue at one end is overlapped with at least one groove at a corresponding other end of two adjacent cylindrical target segments, as viewed in the radial and/or the axial direction, the overlap extending at least along a part of a circumference of the corresponding end.

2. The sputtering target of claim 1, wherein the at least two ends of the at least two cylindrical target segments facing each other form a tongue-groove-fit with each other in such a way that one tongue at the one end is overlapped with one groove at the corresponding other end of two adjacent cylindrical target segments, as viewed in the radial and/or the axial direction.

3. The sputtering target of claim 1, wherein the at least two ends of the at least two cylindrical target segments facing each other form a tongue-groove-fit with each other in such a way that one end with more than one tongue and/or groove is overlapped with the other end with more than one groove and/or tongue, such that each tongue is overlapped with a corresponding faced groove, or each groove is overlapped with a corresponding faced tongue, as viewed in the radial and/or the axial direction.

4. The sputtering target of any one of claims 1 to 3, wherein the at least one tongue of one end and at least one groove of corresponding another end are arranged within an inner extent of 75% of a maximum thickness in a radial plane of the corresponding ends of two adjacent cylindrical target segments, as viewed in the radial direction.

5. The sputtering target of any one of claims 1 to 4, wherein the overlap extends along an entire circumference of two adjacent target segments to provide the tongue-groove-fit, as viewed in the radial plane.

6. The sputtering target of any one of claims 1 to 5, wherein the tongue is a ridge having a rectangular cross-section and two parallel side walls, and the groove is a trough having a rectangular cross-section and two parallel side walls.

7. The sputtering target of any one of claims 1 to 6, wherein the tongue-groove-fit is established segment by segment along the circumference of two adjacent target segments, as viewed in the radial and/or axial direction.

8. The sputtering target of any one of claims 1 to 7, wherein a protrusion is arranged on one member of the tongue and groove and a corresponding trough is arranged on the other member of the tongue and recess, the protrusion and the trough being engageable by relative rotation between two adjacent target segments.

9. The sputtering target of any one of claims 1 to 8, further comprising:
a circumferential sealing member extending circumferentially along a gap between two adjacent target segments.

10. The sputtering target of claim 9, wherein the circumferential sealing member is arranged in the trough formed in two adjacent target segments.

11. The sputtering target of any one of claims 1 to 10, wherein the target segment is made of a metallic material.

12. The sputtering target of claim 11, wherein the target segment is made of a molybdenum- and/or tungsten-based material.

13. The sputtering target of any one of claims 1 to 12, wherein the bonding material is a solder.

14. The sputtering target of claim 13, wherein the bonding material is a indium solder or an indium alloy solder.

15. The sputtering target of claim 1, further comprising:
at least one cylindrical target segment arranged on the tubular backing tube, the tubular backing tube extending along the axial direction through at least 90% of a total length of the at least one cylindrical target segment;
a stop member at an axial end region of the tubular backing tube monolithically formed with the tubular backing tube and radially protruding along the tubular backing tube, and extending at least along a part of the circumference of the tubular backing tube; and
a circumferential sealing member inserted between the stop member and the adjacent target segment to prevent leakage of the bonding material.

16. A method for manufacturing a sputtering target, comprising:
providing a tubular backing tube and at least two cylindrical target segments, an axis of the tubular backing tube being defined as an axial direction, a plane in which a radial direction lies being perpendicular to the axial direction, and the ends of the target segments having at least one tongue or at least one groove;
providing a bonding material arranged between the tubular backing tube and the at least two cylindrical target segments;
juxtaposing cylindrical target segments along the axial direction on the tubular backing tube, at least two ends of the at least two cylindrical target segments facing each other forming a tongue-groove-fit with each other in such a way that at least one tongue at one end is overlapped with at least one groove at a corresponding other end of two adjacent cylindrical target segments, as viewed in the radial and/or axial direction, the overlap extending at least along a part of a circumference of the corresponding end; and
bonding the at least two cylindrical target segments to the tubular backing tube.
